# FASCICULE DE BREVET EUROPEEN

(11) **EP 3 711 085 B1**
(45) Date de publication et mention de la délivrance du brevet: **05.08.2026**
(21) Numéro de dépôt: 18799807.5
(22) Date de dépôt: 15.11.2018
(51) Int. Cl.: H10P 14/20, H10P 14/24, H10P 56/00

(54) **PROCÉDÉ DE FABRICATION DE COUCHE MINCE TRANSFÉRABLE**
VERFAHREN ZUR HERSTELLUNG EINER ÜBERTRAGBAREN DÜNNSCHICHT
PROCESS FOR FABRICATING A TRANSFERABLE THIN LAYER

(30) Priorité: 15.11.2017 FR 1760749
(43) Date de publication de la demande: 23.09.2020
(73) Titulaire: Centre National de la Recherche Scientifique, 75016 Paris (FR); Institut Photovoltaïque D'ile De France (IPVF), 92160 Antony (FR); Ecole Polytechnique, 91128 Palaiseau Cedex (FR); L'Air Liquide, Société Anonyme pour l'Etude et l'Exploitation des Procédés Georges Claude, 75007 Paris (FR); TotalEnergies OneTech, 92400 Courbevoie (FR); Electricité de France, 75008 Paris (FR)
(72) Inventeur: ROCA I CABAROCCAS, Père, 91140 Villebon-sur-Yvette (FR); CARIOU, Romain, 92340 Bourg-la-Reine (FR); CHEN, Wanghua, 91440 Bures-sur-Yvette (FR)
(74) Mandataire: IPAZ
(86) Numéro de dépôt international: PCT/EP2018/081461
(87) Numéro de publication internationale: WO 2019/096947

(56) Documents cités:
- JP-A- 2003 017 723
- US-A1- 2012 208 358
- US-B1- 9 349 864
- US-B1- 9 620 356
- HADJADJ A ET AL: "Ellipsometry investigation of the amorphous-to-microcrystalline transition in a-Si:H under hydrogen-plasma treatment", JOURNAL OF APPLIED PHYSICS, AMERICAN INSTITUTE OF PHYSICS, US, vol. 107, no. 8, 27 April 2010 (2010-04-27), pages 83509 - 83509, XP012133914, ISSN: 0021-8979, DOI: 10.1063/1.3393273

## Description

La présente invention concerne le domaine des dispositifs comprenant une ou plusieurs couches minces, appelé également matériau multicouches, des dispositifs électroniques ou optoélectroniques, et en particulier des dispositifs semi-conducteurs, et notamment des cellules photovoltaïques. L'invention concerne également le domaine des nanotechnologies, de l'optoélectronique et du photovoltaïque.

### Etat de la technique

Différents procédés de fabrication de dispositifs présentant des couches minces sont connus de l'état de la technique. On connaît particulièrement différentes méthodes de préparation de dispositifs semi-conducteurs, en particulier pour la fabrication de cellules photovoltaïques. Parmi ces techniques, on retrouve la préparation de couches minces par épitaxie. Une fois la couche mince épitaxiée, on peut réaliser un décollement ou détachement de cette couche de son substrat et son transfert vers un autre substrat d'intérêt, ou par exemple moins couteux. Pour ce décollement ou détachement, on peut citer à titre d'exemple les méthodes suivantes :
- Le procédé Smartcut^{™} de SOITEC permettant de transférer de fines couches cristallines d'un substrat donneur à un substrat support. Cette technologie est basée sur l'association de l'implantation d'ions légers, en particulier d'hydrogène, et du collage par adhésion moléculaire pour transférer des couches monocristallines ultrafines d'un substrat à un autre ;
- Les procédés basés sur l'utilisation de silicium poreux : au moins deux régions avec des porosités différentes sont créées sous la surface du substrat par gravure électrochimique (« electrochemical etching ») en solution HF, avant épitaxie. Un traitement de recuit à haute température permet de rompre la zone poreuse pour détacher la partie d'intérêt ;
- Les procédés à couche sacrificielle agissant comme tampon cristallin de croissance épitaxiale et qui peut être gravée ou retirée après dépôt. Cette méthode est principalement utilisée pour les semi-conducteurs III-V épitaxiés.

Ces méthodes sont toutefois soit coûteuses, soit difficiles à mettre en œuvre, soit limitées dans leurs applications. L'inconvénient de ces procédés est qu'ils font intervenir des étapes d'implantation d'ions H+, et/ou de traitement thermique à haute température (>700°C) qui sont des étapes compliquées à mettre en œuvre et coûteuses. Un recuit à haute température limite aussi les procédés aux substrats de silicium cristallin ou matériaux réfractaires capables de supporter la température de recuit. La croissance épitaxiale a déjà démontré qu'elle était une voie appropriée pour la production de couches monocristallines ultrafines, notamment puisqu'elle permet de contrôler parfaitement l'épaisseur de la couche et le dopage. De plus la croissance peut se réaliser à faible température (<200 °C) de manière à ce que l'épitaxie soit un procédé à bas coût. Cependant, dans ce type de procédé, le transfert des couches épitaxiées vers un substrat à faible coût est une étape cruciale. Ainsi, il existe un besoin de développer des procédés innovants permettant de répondre aux problèmes techniques existants.

### Buts de l'invention

La présente invention a pour but de résoudre le problème technique consistant à fournir un procédé de fabrication d'un matériau semi-conducteur cristallin comprenant au moins une couche semi-conductrice entièrement monocristalline facilement détachable du substrat sur lequel cette ou ces couches semi-conductrices sont préparées , notamment dans le but de transférer la ou les couches semi-conductrices sur un autre substrat, de préférence à faible coût ou possédant des propriétés d'intérêt. En particulier, on souhaite utiliser un deuxième substrat présentant un cout moins élevé que le premier substrat ou un substrat flexible par exemple. La présente invention a pour but de résoudre le problème technique consistant à fournir un procédé dans lequel le premier substrat est recyclable.

La présente invention a également pour but de résoudre le problème technique consistant à fournir un procédé de fabrication d'un matériau semi-conducteur multicouches peu coûteux.

La présente invention a également pour but de résoudre le problème technique consistant à fournir un procédé de fabrication d'un matériau semi-conducteur multicouches facile à mettre en œuvre, en particulier pour envisager différentes applications industrielles.

La présente invention a encore pour but de résoudre le problème technique consistant à fournir un procédé de préparation de cellules photovoltaïques.

La présente invention a aussi pour but de résoudre le problème technique consistant à fournir de nouveaux matériaux semi-conducteurs multicouches, par exemple pour des applications dans des cellules photovoltaïques, en particulier pour des cellules photovoltaïques dont le substrat n'est pas celui de croissance.

La présente invention a encore pour but de résoudre le problème technique consistant à fournir des matériaux comprenant une ou plusieurs couches semi-conductrices déposées sur un substrat souple ou flexible.

### Description détaillée de l'invention

Les présents inventeurs ont découvert un nouveau procédé de préparation permettant de résoudre un ou plusieurs des problèmes techniques énoncés ci-dessus. Ce procédé permet la préparation de matériaux semi-conducteurs permettant de résoudre un ou plusieurs des problèmes techniques énoncés ci-dessus.

La présente invention concerne en particulier un procédé de préparation d'un matériau semi-conducteur comprenant au moins une couche semi-conductrice entièrement monocristalline selon la revendication 1.

Le dépôt de très fines couches de silicium monocristallin (ou couche ultrafine) par PECVD est déjà décrite, par exemple dans Roca i Cabarrocas et al. 2012 (Pere Roca i Cabarrocas, Romain Cariou, Martin Labrune. Low temperature plasma deposition of silicon thin films: From amorphous to crystalline. Journal of Non-Crystalline Solids, Elsevier, 2012, 358 (17), pp.2000-2003. <10.1016/j.jnoncrysol.2011.12.113>. <hal-00806450>). Cependant dans les dépôts par PECVD selon l'art antérieur, les conditions sont stationnaires, c'est-à-dire que les conditions pour générer le plasma ne varient pas. Or il a été mis en évidence par les présents inventeurs que le gradient de vitesse de croissance épitaxiale permet de générer une zone fragile dans la couche de silicium monocristallin apte à être rompue pour séparer les couches en contact de part et d'autre de la zone fragile du silicium monocristallin. On peut ainsi détacher facilement du premier substrat le silicium monocristallin et les couches déposées sur la face opposée au premier substrat.

On entend par « gradient de vitesse de croissance épitaxiale », des conditions de PECVD imposant des vitesses différentes de dépôt de couches d'épaisseur nanométrique. Ces conditions de PECVD peuvent être facilement constatées par les paramètres de fonctionnement de l'appareillage apte à réaliser le PECVD qui varient lors de l'étape de PECVD et/ou par des variations dans les propriétés mécaniques et/ou la composition chimique (contenu en hydrogène en particulier) de couches ainsi déposées.

Le procédé de l'invention comprend, après la croissance épitaxiale à l'étape (iii), (iv) le détachement au moins de la couche de matériau semi-conducteur formée par croissance épitaxiale à l'étape (iii) pour sa séparation physique du premier substrat et (v) le transfert au moins de la couche de matériau semi-conducteur formée par croissance épitaxiale sur un deuxième substrat.

Selon une variante, la préparation (i) de la surface d'un premier substrat comprend l'élimination des oxydes présents à la surface du premier substrat destiné à recevoir la couche de silicium.

Pour l'élimination des oxydes présents à la surface du premier substrat, on peut utiliser une méthode de nettoyage quelconque, connue de l'homme du métier.

Selon un mode de réalisation, l'élimination des oxydes présents à la surface du premier substrat est réalisée par une méthode de nettoyage comprenant la mise en œuvre d'une ou plusieurs solutions chimiques à base d'acide fluorhydrique ou alcalines et/ou de plasma à base de fluorure (SF₆, SiF₄, NF₃, F₂).

Il n'y a pas de limitation particulière concernant le premier substrat tant qu'il est possible de déposer une couche de silicium par croissance épitaxiale à sa surface. Selon un mode de réalisation, le premier substrat est choisi parmi : Si, Ge, SiGe, ou un autre matériau semi-conducteur, comme par exemple un matériau semi-conducteur de type III-V.

A titre de matériau semi-conducteur de type III-V, on peut citer les composés d'un ou plusieurs éléments de la colonne III (bore, gallium, aluminium, indium, etc.) et de la colonne V (arsenic, antimoine, phosphore, etc.) du tableau périodique de Mendeleïev, tels que par exemple GaN, GaP, GaAs, GaSb, InN, InP, InAs, BN, BP, Bas, AIN, AIP, ou des alliages ternaires tels que par exemple InₓGa₁₋ₓAs, AlₓGa₁₋ₓAs. On peut aussi citer les alliages semi-conducteurs d'éléments appartenant au groupe 12 et aux chalcogènes, comme par exemple CdS, CdSe, CdTe, ZnO, ZnS, ZnTe, CdZnTe (CZT), ou encore le séléniure de cuivre-indium (CIGS).

Typiquement, le premier substrat est un « wafer » de silicium, c'est-à-dire une « tranche », « galette », « gaufrette », « plaque » ou « plaquettes » de silicium. Les plaquettes de silicium peuvent être de différentes tailles et sont en général un disque de diamètre 100 mm à 300 mm ou un pavé carré de côté de 20 mm à 500 mm. L'épaisseur est en général de l'ordre de 0,1 à 1 mm et typiquement de l'ordre de 0,3 mm.

Avantageusement, après détachement du matériau comprenant une ou plusieurs couches semi-conductrices, le premier substrat est recyclé pour une nouvelle utilisation. Typiquement, le substrat subit un traitement de nettoyage pour éliminer la couche de silicium épitaxiée et présente ainsi une surface de silicium cristallin destinée par exemple à recevoir une nouvelle couche de silicium déposée par PECVD, selon par exemple le procédé selon la présente invention. On peut ainsi recycler la plaquette de silicium dans le cadre du procédé selon la présente invention.

Le PECVD est un procédé typiquement utilisé pour déposer des couches minces sur un substrat à partir d'un état gazeux (vapeur).

Avantageusement, le dépôt par PECVD est mis en œuvre en régime intermédiaire entre le régime épitaxial et microcristallin. Le dépôt par PECVD selon la présente invention permet ainsi de former au moins une couche fragile au sein de la couche de silicium monocristallin incorporant une concentration élevée d'atomes d'hydrogène.

Avantageusement, le dépôt (ii) par PECVD est mis en œuvre pour la formation d'un plasma formant des radicaux SiH₃ puis d'un plasma formant des agrégats de silicium (« silicon clusters »).

Ainsi, la présente invention permet avantageusement de former dans la même étape de croissance épitaxiale par PECVD du silicium une zone de fragilité du fait des conditions de dépôt.

En particulier, le dépôt par PECVD comprend un gradient de vitesse de croissance de la couche monocristallin de silicium. En particulier, ce gradient peut être concrétisé par des vitesses de croissance différentes. Il peut s'agir d'une variation discontinue de la vitesse de dépôt, avec par exemple de deux ou trois vitesses de dépôt différentes, ou d'une variation continue de la vitesse de dépôt. Les vitesses de croissance par PECVD sont déterminées par exemple par le paramétrage de l'appareillage et/ou des conditions de dépôt. On peut ainsi par exemple utiliser différentes densités de puissances du plasma, pressions, débit de gaz, ou température du substrat pour obtenir un gradient de vitesse de croissance et ainsi des vitesses de croissance différentes.

Dans différents modes de réalisation possibles, la présente invention concerne également les caractéristiques suivantes qui pourront être considérées isolément ou selon toutes leurs combinaisons techniquement possibles et apportent chacune des avantages spécifiques, pour l'étape (ii) et/ou (iii) de PECVD:
- la durée est comprise par exemple entre 10 secondes et 10 minutes,
- la densité de puissance du plasma radiofréquence est par exemple de 10 à 250 mW/cm2,
- la pression du mélange gazeux est par exemple de 200 à 400 Pa,
- la température de dépôt est par exemple de 100 à 400 °C,
- le débit gazeux de SiH₄ est par exemple de 0,5 à 5 sccm (signifiant « standard cubic centimer per minute » soit cm³/min exprimé en conditions standard de température et de pression),
le débit gazeux d'hydrogène est par exemple de 10 à 500 Ncm3/min (exprimé en conditions standard de température et de pression).

La présence d'hydrogène influence de manière importante la stabilité et le stress mécanique de la couche déposée. Selon la présente invention, cette propriété est utilisée pour permettre ultérieurement de détacher très facilement la ou les couches déposées sur la couche de silicium monocristallin obtenue par PECVD.

Avantageusement, la température de dépôt (ii) par PECVD et de croissance épitaxiale (iii) est inférieure à 400 °C. Une telle température permet avantageusement de diminuer le coût de fonctionnement du procédé de fabrication. Avantageusement, la température de dépôt par PECVD et de croissance épitaxiale est inférieure à 250 °C. - Typiquement, la température est de 200 °C.

Avantageusement, la couche de silicium obtenue par croissance épitaxiale par PECVD présente un gradient de composition. On entend par gradient de composition par exemple une composition présentant une concentration d'atomes d'hydrogène variant dans l'épaisseur de la couche de silicium obtenue par PECVD. Typiquement, selon la présente invention, la couche de silicium obtenue par PECVD présente un pic de concentration d'hydrogène. Ce pic de concentration d'hydrogène est en général à l'interface entre le substrat et la première couche épitaxiée. Le pic de concentration d'hydrogène peut dépasser 1x10²¹ atomes/cm³, et par exemple dépasser 2x10²¹ atomes/cm³. La concentration d'hydrogène est par exemple mesurée par spectrométrie de masse à ionisation secondaire qui est un procédé d'analyse de surface (SIMS, d'après l'acronyme anglais signifiant « secondary ion mass spectrometry »). On peut parler également de gradient de cristallinité pour cette couche de silicium du fait des défauts de cristallinité du silicium introduit par les atomes d'hydrogène. On peut aussi parler de gradient de densité.

Selon un mode de réalisation, on peut constater la présence d'une zone de fragilité dans le matériau entièrement monocristallin car l'interface substrat/couche de silicium présente par ellipsométrie spectroscopique des oscillations (interférences) dans la gamme d'énergie de photon de 0,7 à 3 eV, et de préférence dans la gamme d'énergie de photon de 1,5 à 2.5 eV.

Avantageusement, le dépôt par PECVD permet de contrôler l'épaisseur de la couche déposée. La couche a par exemple une épaisseur de 1 nm à 10 µm.

Une fois la couche de silicium déposée par PECVD, on peut faire croître sur le silicium une ou plusieurs couches monocristallines d'un ou plusieurs matériaux semi-conducteurs. Selon un mode de réalisation, les couches monocristallines du matériau ne sont pas identiques et comprennent par exemple différents matériaux semi-conducteurs d'une couche à l'autre. Selon un mode de réalisation, les couches monocristallines du matériau sont identiques dans la nature chimique du matériau semi-conducteur utilisé, le matériau pouvant éventuellement différer par un dopage ou une structuration physique.

Pour la ou les couches de matériaux semi-conducteurs déposées sur la couche de silicium déposée par PECVD avec gradient de croissance, on peut faire référence aux matériaux semi-conducteurs énoncés précédemment.

Selon une variante, la croissance épitaxiale (iii) est mise en œuvre avec un ou plusieurs éléments choisis parmi : Si, Ge, SiGe.

Selon une variante, la croissance épitaxiale (iii) est mise en œuvre avec une technique choisie parmi PECVD, CVD, MBE, ou l'une quelconque de leurs combinaisons.

Les conditions de croissance de la couche épitaxiée (étape (iii)) sont par exemple les suivantes (PECVD): température: 200°C, pression: 307 Pa, puissance: 35 mW/cm2, SiH₄: 4 SCCM (Ncm³.min⁻¹), H₂: 200 SCCM (Ncm³.min⁻¹), temps de dépôt: 1800 sec.

Typiquement, la technique de transfert (v) sur le second substrat est choisie parmi une technique comprenant : un collage ionique (ou « anodic bonding » en anglais), ou l'utilisation de silicone, d'un ruban de polyimide ou d'une colle à haute température (par exemple du Ormostamp^{®}), ou l'une quelconque de leurs combinaisons.

OrmoStamp^{®} est un polymère hybride inorganique-organique pour la fabrication de tampons de travail transparents utilisés en nanolithographie (Lithographie par Nano-Impression ou NIL) comme alternative économique au quartz ou aux tampons galvanisés. Il peut être appliqué en NIL thermique et/ou NIL UV.

L'invention permet également de réaliser des empilements de couches dopées et/ou non dopées pour former des jonctions P-N, N-P, PIN ou NIP ou des combinaisons de telles jonctions. Le dopage peut être par exemple un dopage au Phosphore et/ou au Bore avec une concentration de dopage par exemple de < 1 × 10²⁰ at./cm³.

Une fois la ou les couches de matériaux semi-conducteurs déposés sur la couche de silicium monocristallin obtenue par PECVD selon la présente invention, il est possible de détacher facilement la ou les couches de matériaux semi-conducteurs du premier substrat pour les séparer physiquement du premier substrat. On peut par exemple utiliser une étape de chauffage (dite généralement de recuit) à une température par exemple de 250 à 400 °C. Cette étape de chauffage permet avantageusement de fragiliser davantage l'interface entre le substrat et la couche de silicium épitaxiée par PECVD ce qui permet de séparer l'échantillon en deux parties distinctes, l'une comprenant le premier substrat, l'autre comprenant la ou les couches de matériaux semi-conducteurs.

Avantageusement, on peut déposer plusieurs couches de matériaux sur le silicium épitaxié par PECVD. Cela permet avantageusement de détacher un matériau multicouches du premier substrat. On peut ainsi préformer plusieurs couches de semi-conducteur aptes à fonctionner dans une cellule photovoltaïque.

Selon une variante, on forme des hétérojonctions directement sur le premier substrat. On peut par exemple transférer cette hétérojonction sur un deuxième substrat.

La ou les couches de matériaux semi-conducteurs détachées du premier substrat peuvent être donc déposées sur un deuxième substrat.

Selon une variante, le détachement (iv) de la couche de matériaux semi-conducteur est réalisé par traitement mécanique ou thermique, ou l'une quelconque de leurs combinaisons, et par exemple réalisé par clivage à l'interface poreuse par la application d'une contrainte mécanique, d'ultrasons et/ou jet d'eau. On obtient ainsi un film multicouche autosupporté. Le film multicouche peut être ensuite transféré sur un deuxième substrat formant un support mécanique souple ou rigide, par exemple non cristallin, et le premier substrat cristallin peut être réutilisé.

Avantageusement, le premier substrat est recyclé. On peut par exemple recycler le premier substrat en nettoyant sa surface. Les conditions de nettoyage du premier substrat sont connues de l'homme du métier et sont par exemple les conditions de recyclage de la technologie Smartcut^{™}.

Selon une variante, le deuxième substrat est choisi parmi : verre, un métal ou alliage de métal, un polymère, y compris choisi parmi les co-polymères, un matériau flexible, un élastomère, et un élastomère thermoplastique.

Selon un mode de réalisation, le deuxième substrat est flexible ou souple, c'est à dire que les propriétés mécaniques du substrat permettent de le manipuler physiquement pour modifier sensiblement sa forme physique en utilisant une force (par exemple par flexion) sans briser le substrat.

L'invention concerne un matériau susceptible d'être obtenu par un procédé selon la présente invention.

L'invention permet en particulier d'utiliser une couche de silicium très fine ou dite ultra-fine, c'est-à-dire d'une épaisseur très faible. Cette épaisseur est typiquement de 1 nanomètre (nm) à 10 micromètres (µm), et par exemple de 1 nm à 500 nm, de 1 nm à 200 nm ou encore de 1 µm à 10 µm.

Parmi les exemples de dispositifs comprenant un ou plusieurs matériaux selon l'invention, on peut lister notamment :
- Jonctions P-N ;
- Jonctions P-I-N ;
- Structures tandem P-N/P-N ou P-I-N/P-I-N ;
- Hétérojonctions ;
- Toute combinaison des empilements précédents ; et
- -Circuits électriques 3D.

Par exemple, on peut citer un circuit 3D intégré avec des puces, par exemple de 5 à 10 µm d'épaisseur. Un tel circuit 3D peut être utilisé par exemple comme couches dans des empilements 3D. Par exemple, on peut mentionner un matériau multicouches comprenant les couches suivantes : verre/ITO/c-Si/ZnO/Ag, où le Si est monocristallin (c-Si).

Avantageusement, la présente invention permet de transférer une ou plusieurs couches d'un matériau semi-conducteur utilisable pour différentes applications.

On peut par exemple utiliser un matériau semi-conducteur multicouches selon la présente invention pour la fabrication de plaques de silicium sur isolant (SOI).

La fabrication de matériaux semi-conducteurs monocristallins multicouches de faible épaisseur (film fin, connu sous la dénomination anglo-saxonne «thin layer » ou « ultra thin layer » si l'épaisseur est très faible), est une étape clé pour le développement de dispositifs électroniques ou photovoltaïques à faible coût et/ou flexibles. La présente invention permet de fournir de tels dispositifs.

La présente invention concerne un procédé dans lequel le premier substrat est recyclable, un procédé de fabrication d'un matériau semi-conducteur multicouches peu coûteux, un procédé de fabrication de couches d'un matériau semi-conducteur multicouches facile à mettre en œuvre, en particulier pour envisager différentes applications industrielles, un procédé de préparation de cellules photovoltaïques.

La présente invention concerne aussi fournir de nouveaux matériaux semi-conducteurs multicouches, par exemple pour des applications dans des cellules photovoltaïques, en particulier pour des cellules photovoltaïques dont le substrat n'est pas celui de croissance, ou encore des matériaux comprenant une ou plusieurs couches de semi-conducteurs déposées sur un substrat souple ou flexible.

Les matériaux multicouches selon la présente invention peuvent être en particulier utilisés dans des dispositifs comprenant une ou plusieurs couches minces, des dispositifs électroniques, optoélectroniques, et en particulier des dispositifs semi-conducteurs, et notamment des cellules photovoltaïques. L'invention concerne également le domaine des nanotechnologies et de l'optoélectronique.

Sur les figures :
La figure 1 représente une mesure par ellipsométrie spectroscopique dans les conditions de l'exemple 1.
La figure 2 représente une mesure par SIMS dans les conditions de l'exemple 1.

### Exemples

### Exemple 1

Il a été préparé deux matériaux multicouches, l'un selon un procédé de la présente invention avec un gradient de vitesse de croissance épitaxiale de la couche de silicium monocristallin, l'autre, comparatif, avec une vitesse constante de croissance épitaxiale par PECVD.

Une fine couche de silicium d'épaisseur 600 nm a été ainsi préparée selon ces deux procédés PECVD.

Pour les deux échantillons (comparatif et selon l'invention), la couche de silicium déposée par PECVD est déposée par croissance directe sur la plaquette de silicium nettoyée (libre d'oxyde natif).

Pour l'exemple selon la présente invention, trois conditions de plasma PECVD ont été utilisées.

Les premières conditions de dépôt PECVD sont les suivantes :
Température : 200 °C ;
Pression : 240 Pa ;
Puissance: 35 mW/cm² ;
Débit SiH4: 2 sccm;
Débit H2: 200 sccm ; Durée: 60 sec.

Les deuxièmes conditions de dépôt PECVD sont les suivantes:
Température: 200°C;
Pression: 227 Pa;
Puissance: 17 mW/cm² ;
Débit SiH4: 1 sccm ;
Débit H2: 200 sccm ;
Durée: 60 sec.

Les troisièmes conditions de dépôt PECVD sont la suivantes:
Température: 200°C ;
Pression: 307 Pa ;
Puissance: 35 mW/cm² ;
Débit SiH4: 4 sccm ;
Débit H2: 200 sccm ;
Durée: 1800 sec.

Pour l'échantillon comparatif, la couche de silicium a été déposée par PECVD sans gradient de vitesse de croissance épitaxiale uniquement selon les troisièmes conditions de dépôt PECVD.

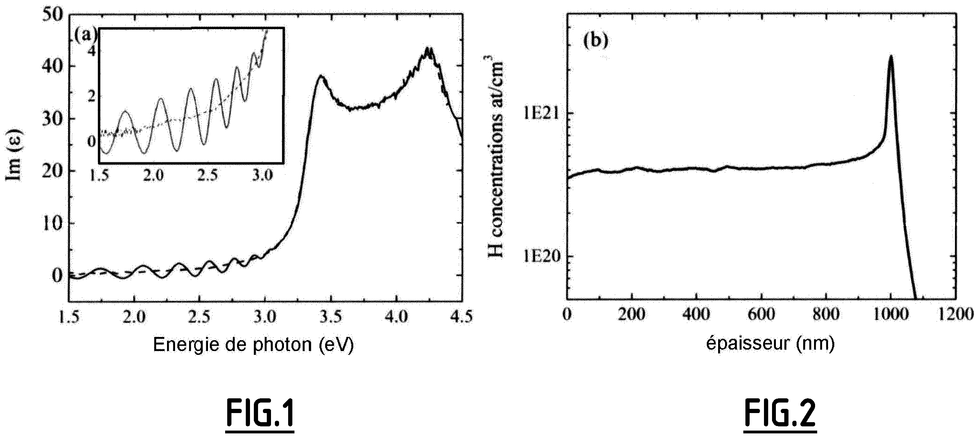

Les résultats de mesures par ellipsométrie spectroscopique sont illustrés sur la figure 1. On note qu'à faible énergie, la partie imaginaire de la fonction pseudodiélectrique εi présente des oscillations qui sont caractéristiques de la porosité de l'interface entre le substrat (plaquette de silicium monocristallin) et la couche de silicium déposée par PECVD. La forte porosité de l'interface est détectée pour l'échantillon conforme à la présente invention comme illustré par une amplitude élevée des oscillations à faible énergie. L'amplitude d'oscillation est significative en comparaison à l'échantillon comparatif. On note que dans la partie à énergie plus élevée (supérieure à 3 eV), le spectre est très similaire à la plaquette de silicium démontrant ainsi la qualité cristalline du matériau selon la présente invention.

Sur la figure 2, on note le profil de concentration en hydrogène caractérisé par SIMS pour les deux échantillons. Pour l'échantillon conforme à la présente invention, l'interface est très poreuse avec une forte accumulation d'hydrogène à la surface en contact avec la plaquette de silicium (jusqu'à 2,5x10²¹ atomes/cm³). Un tel pic de concentration n'est pas observé dans l'échantillon comparatif dont la concentration d'hydrogène est d'environ 3x10²⁰ atomes/cm³.

Ensuite, pour le matériau conforme à l'invention, le transfert de la couche de silicium a été réalisé avec succès sur du verre par exemple par liaison anodique à 200 °C pendant 10 minutes puis recuit à 200°C pendant 5 minutes. Au contraire, pour l'échantillon comparatif, dans les mêmes conditions il n'est pas possible de détacher la couche déposée par PECVD. On ne note aucun détachement même avec un recuit à 550°C pendant 5 minutes, alors même lorsque que la plaquette de silicium se brise.

Ainsi, le procédé selon la présente invention permet un transfert simple à faible coût d'un matériau semi-conducteur sur un substrat qui peut être moins couteux que le silicium.

### Exemple 2

Dans les mêmes conditions que l'exemple 1, la couche fine de silicium a été transférée sur un substrat flexible.

On peut ainsi obtenir un matériau semi-conducteur cristallin sur substrat flexible.

## Revendications

1. Procédé de préparation d'un matériau semi-conducteur comprenant au moins une couche semi-conductrice entièrement monocristalline, ledit procédé comprenant les étapes :
(i) la préparation de la surface d'un premier substrat pour recevoir une couche de silicium monocristallin ;
(ii) le dépôt par dépôt chimique en phase vapeur assisté par plasma d'une couche de silicium monocristalline par croissance épitaxiale avec un gradient de vitesse de croissance sur le premier substrat préparé à l'étape (i) pour former, dans la même étape de croissance épitaxiale par PECVD du silicium, une zone de fragilité en utilisant différentes densités de puissances du plasma, pressions, débit de gaz, ou température du substrat ; et
(iii) la croissance épitaxiale d'une couche monocristalline d'un matériau semi-conducteur sur la couche de silicium monocristalline obtenue à l'étape (ii), et ainsi l'obtention d'un matériau comprenant au moins une couche semi-conductrice entièrement monocristalline ;
(iv) le détachement au moins de la couche de matériau semi-conducteur formée par croissance épitaxiale à l'étape (iii) pour sa séparation physique du premier substrat ; et
(v) le transfert au moins de la couche de matériau semi-conducteur formée par croissance épitaxiale sur un deuxième substrat.

2. Procédé selon la revendication 1, **caractérisé en ce que** la préparation (i) de la surface d'un premier substrat comprend l'élimination des oxydes présents à la surface du premier substrat destiné à recevoir la couche de silicium.

3. Procédé selon la revendication 1 ou selon la revendication 2, **caractérisé en ce que** le dépôt (ii) par PECVD est mis en oeuvre pour la formation d'un plasma formant des radicaux SiH₃ puis d'un plasma formant des agrégats de silicium.

4. Procédé selon l'une quelconque des revendications 1 à 3, **caractérisé en ce que** la température de dépôt (ii) par PECVD et de croissance épitaxiale (iii) est inférieure à 400 °C.

5. Procédé selon l'une quelconque des revendications 1 à 4, **caractérisé en ce que** la croissance épitaxiale (iii) est mise en œuvre avec un ou plusieurs éléments choisis parmi : Si, Ge, SiGe.

6. Procédé selon l'une quelconque des revendications 1 à 5, **caractérisé en ce que** la croissance épitaxiale (iii) est mise en oeuvre avec une technique choisie parmi PECVD, CVD, MBE, ou l'une quelconque de leurs combinaisons.

7. Procédé selon la revendication 1, **caractérisé en ce que** la technique de dépôt (v) sur le second substrat est choisie parmi une technique comprenant : un collage ionique, ou l'utilisation de silicone, d'un ruban de polyimide ou d'une colle à haute température, ou l'une quelconque de leurs combinaisons.

8. Procédé selon la revendication 1, **caractérisé en ce que** le détachement (iv) de la couche de matériaux semi-conducteur est réalisé par traitement mécanique ou thermique, ou l'une quelconque de leurs combinaisons.

## Patentansprüche

1. Verfahren zum Herstellen eines Halbleitermaterials, umfassend mindestens eine vollständig einkristalline Halbleiterschicht, das Verfahren umfassend die Schritte:
(i) Herstellen der Oberfläche eines ersten Substrats zum Aufnehmen einer Schicht aus einkristallinem Silizium;
(ii) Abscheiden einer einkristallinen Siliziumschicht durch plasmaunterstützte chemische Gasphasenabscheidung durch epitaktisches Wachstum mit einem Wachstumsratengradienten auf das erste Substrat, das in Schritt (i) hergestellt wird, zum Ausbilden, in demselben Schritt des epitaktischen Wachstums durch Silizium-PECVD, einer Schwächungszone unter Verwendung von unterschiedlichen Plasmaleistungsdichten, Drücken, einem Gasdurchfluss oder einer Temperatur des Substrats; und
(iii) epitaktisches Wachsen einer einkristallinen Schicht eines Halbleitermaterials auf der einkristallinen Siliziumschicht, die in Schritt (ii) erhalten wird, und somit Erhalten eines Materials, umfassend mindestens eine vollständig einkristalline Halbleiterschicht;
(iv) Ablösen mindestens der Schicht aus Halbleitermaterial, die in Schritt (iii) durch epitaktisches Wachstum ausgebildet wird, zu ihrer physischen Trennung von dem ersten Substrat; und
(v) Übertragen mindestens der Schicht aus Halbleitermaterial, die durch epitaktisches Wachstum ausgebildet wird, auf ein zweites Substrat.

2. Verfahren nach Anspruch 1, **dadurch gekennzeichnet, dass** das Herstellen (i) der Oberfläche eines ersten Substrats die Entfernung der Oxide umfasst, die auf der Oberfläche des ersten Substrats vorhanden sind, das zum Aufnehmen der Siliziumschicht bestimmt ist.

3. Verfahren nach Anspruch 1 oder 2, **dadurch gekennzeichnet, dass** das Abscheiden (ii) durch PECVD für die Ausbildung eines Plasmas, das SiH₃-Radikale ausbildet, dann eines Plasmas, das Siliziumaggregate ausbildet, implementiert wird.

4. Verfahren nach einem der Ansprüche 1 bis 3, **dadurch gekennzeichnet, dass** die Temperatur des Abscheidens (ii) durch PECVD und des epitaktischen Wachstums (iii) unter 400 °C liegt.

5. Verfahren nach einem der Ansprüche 1 bis 4, **dadurch gekennzeichnet, dass** das epitaktische Wachstum (iii) mit einem oder mehreren Elementen implementiert wird, die ausgewählt sind aus: Si, Ge, SiGe.

6. Verfahren nach einem der Ansprüche 1 bis 5, **dadurch gekennzeichnet, dass** das epitaktische Wachstum (iii) mit einer Technik implementiert wird, die aus PECVD, CVD, MBE oder einer beliebigen ihrer Kombinationen ausgewählt ist.

7. Verfahren nach Anspruch 1, **dadurch gekennzeichnet, dass** die Abscheidungstechnik (v) auf dem zweiten Substrat aus einer Technik ausgewählt ist, umfassend: ein ionisches Anhaften oder die Verwendung von Silikon, einem Polyimidband oder einem Hochtemperaturhaftstoff oder eine beliebige Kombination davon.

8. Verfahren nach Anspruch 1, **dadurch gekennzeichnet, dass** das Ablösen (iv) der Schicht aus Halbleitermaterial durch mechanische oder thermische Behandlung oder eine beliebige Kombination davon durchgeführt wird.

## Claims

1. Process for the preparation of a semiconductor material comprising at least one entirely monocrystalline semiconductor layer, said process comprising the steps:
(i) preparation of the surface of a first substrate to receive a layer of monocrystalline silicon;
(ii) the plasma-enhanced chemical vapor deposition of a layer of monocrystalline silicon by epitaxial growth with a growth rate gradient on the first substrate prepared in step (i), to form, during the same PECVD epitaxial growth step of the silicon, a region of brittleness by using different plasma power densities, pressures, gas flow rates, or substrate temperatures; and
(iii) epitaxial growth of a monocrystalline layer of a semiconductor material on the monocrystalline silicon layer obtained in step (ii), to thus obtain a material comprising at least one entirely monocrystalline semiconductor layer; and
(iv) detaching of at least the layer of semiconductor material formed by epitaxial growth at step (iii) for its physical separation from the first substrate; and
(v) the transference of at least the layer of semiconductor material formed by epitaxial growth, onto a second substrate.

2. Process according to claim 1, **characterized in that** the preparation (i) of the surface of a first substrate comprises the removal of the oxides present on the surface of the first substrate intended to receive the silicon layer.

3. Process according to claim 1 or 2, **characterized in that** the deposition step (ii) by PECVD is implemented for the formation of a plasma forming SiH₃ radicals then of a plasma forming silicon clusters.

4. Process according to any one of claims 1 to 3, **characterized in that** the deposition temperature step (ii) by PECVD and epitaxial growth step (iii) is less than 400°C.

5. Process according to any one of claims 1 to 4, **characterized in that** the epitaxial growth step (iii) is implemented with one or more elements chosen from among: Si, Ge, SiGe.

6. Process according to any one of claims 1 to 5, **characterized in that** the epitaxial growth step (iii) is implemented with a technique chosen from among PECVD, CVD, MBE, or any of their combinations.

7. Process according to claim 1, **characterized in that** the deposition technique step (v) on the second substrate is chosen from a technique comprising: anodic bonding, or the use of silicone, a polyimide tape or a high temperature glue, or any combination thereof.

8. Process according to claim 1, **characterized in that** the detachment step (iv) of the layer of semiconductor material is carried out by mechanical or thermal treatment, or any one of their combinations.
